(19) Europäisches Patentamt
European Patent Office
Office européen des brevets

(11) **EP 0 667 679 B1**

## (12) EUROPEAN PATENT SPECIFICATION

(45) Date of publication and mention
of the grant of the patent:
**25.06.1997 Bulletin 1997/26**

(51) Int Cl.6: **H03K 19/173**, H01L 23/525

(21) Application number: **94309766.7**

(22) Date of filing: **23.12.1994**

(54) **Improvements in or relating to routing architectures**

Verbindungsarchitekturen

Architectures de routage

(84) Designated Contracting States:
**DE FR GB IT NL**

(30) Priority: **06.01.1994 US 178230**

(43) Date of publication of application:
**16.08.1995 Bulletin 1995/33**

(73) Proprietor: **TEXAS INSTRUMENTS
INCORPORATED
Dallas, Texas 75243 (US)**

(72) Inventor: **Hanwood, Mark G.,
c/o Texas Instruments Inc.
Dallas Tex 75243 (US)**

(74) Representative: **Brown, Angela Mary et al
Texas Instruments Limited,
Wellington House,
61-73 Staines Road West
Sunbury on Thames TW16 7AH (GB)**

(56) References cited:
**EP-A- 0 469 728**     **US-A- 5 250 464**

- **IEEE JOURNAL OF SOLID-STATE CIRCUITS,
  vol.24, no.2, April 1989, NEW YORK, US pages
  394 - 398 A. EL GAMAL ET AL.: 'An Architecture
  for Electrically Configurable Gate Arrays'**
- **MICROPROCESSORS &MICROSYSTEMS,
  vol.13, no.5, June 1989, LONDON, GB pages 305
  - 312 A. HAINES: 'Field-programmable gate array
  with non-volatile configuration'**
- **COMPUTER DESIGN, vol.27, no.14, 1 August
  1988, LITTLETON, MA, US pages 32 - 36 W.
  ANDREWS: 'User-configurable arrays bridge
  gap between gate arrays and PLDs'**

**Description**

TECHNICAL FIELD OF THE INVENTION

The present invention generally relates to integrated circuit technology and, more particularly, to a routing architecture for integrated circuits such as field programmable gate arrays, programmable logic devices, and the like.

BACKGROUND OF THE INVENTION

Integrated electronic circuits are usually fabricated with all internal connections set during the manufacturing process. However, because of the high circuit design and development costs, as well as high tooling costs for making such circuits, a new type of integrated circuits is appearing in the integrated circuit marketplace. These circuits are called user-programmable circuits because a user may program them using a series of programmable links within the circuit. Programmable links are electrical interconnects that the user breaks or makes at selected electronic nodes in the fully fabricated and packaged integrated circuit device. These interconnects occur by programming which activates or deactivates the selected electronic nodes to make the integrated circuit perform the desired functions or set of functions that the user desires.

One type of programmable link, the antifuse link, creates a short or relatively low resistance (e.g., less than 1 K$\Omega$) link between two or more connectors. Antifuse links, or simply antifuses, consist typically of two conductor or semiconductor elements having some kind of dielectric or insulating material between them. During programming, the dielectric at selected points between the conductive elements breaks down due to a current that develops from applying a pre-determined programming voltage to the conductive elements of selected antifuses. This electrically connects the conducting or semiconducting elements.

Undesirable capacitances and leakage currents of unused antifuses are problems that occur in user-programmable integrated circuits that use antifuses. That is, the antifuse, which is normally an open device in its unprogrammed condition, has an associated leakage current between the connectors and produces some degree of capacitance between the connectors. Some antifuses have different characteristics in their non-programmed state. For example, some have lower capacitance (*e.g.*, in the 1 pF range) and others have larger capacitances (*e.g.*, in the 8 pF range). Some antifuses, on the other hand, have lower leakage current levels than others (*e.g.*, less than 1 nA verses 30 nA). They all, however, have leakage currents and capacitances that adversely affect the operation of the user-programmable integrated electronic circuits that use them.

SUMMARY OF THE INVENTION

There is a need, therefore, for an improvement of user-programmable integrated electronic circuits which use antifuses in order to overcome the capacitance and leakage current problems existing in known routing architectures.

The present invention, accordingly provides an improvement for programmable logic devices such as field programmable gate arrays (FPGAs) that overcomes or reduces disadvantages and limitations associated with prior integrated electronic circuit routing architectures.

One aspect of the invention is an integrated electronic circuit that has low leakage current and capacitance and that includes a programmable integrated circuit having a plurality of designed conductors and a plurality of designed functional circuit blocks. In the circuit, a plurality of programmable antifuse elements connect to the plurality of conductors and the plurality of functional circuit blocks. The plurality of programmable antifuses connect the plurality of conductors with one another and to the plurality of functional circuit blocks. The plurality of conductors is segregated into at least two groups having associated ones of the programmable antifuse elements and including a first group and a second group. The first group of antifuse elements includes a sufficiently large number of the programmable antifuse elements so that the associated ones of the programmable antifuse elements contribute a larger portion to the total leakage current and capacitance of the first group than do antifuse elements of the second group contribute to the total leakage current and capacitance of the second group. The antifuse elements that associate with the first group are selectively depopulated to optimally reduce the leakage current and capacitance of the first group and, thereby, lower the leakage current and capacitance of the electronic circuit while minimally reducing programmability of the programmable integrated circuit.

A technical advantage of the present invention is that it reduces the number of antifuses on segments of various lengths in a way that is optimal for the particular gate density of the integrated electronic circuit. Integrated electronic circuits with antifuses use the concepts of the present invention experience reduced signal propagation delays, and reduced peak and average CMOS currents. This is due to the fact that current, i, has the relationship:

$i = fcv$ where,

i = current; f = frequency; c = capacitance, and v = voltage, reduce quiescent leakage currents on antifuses that have DC voltages across them.

Another technical advantage of the present invention is that it provides reduced leakage and reduced net capacitance without increasing the costs of either the associated integrated circuit or the integrated circuit design.

Yet another technical advantage of the present invention is that it reduces the leakage and net capacitance of an integrated electronic circuit that employs the concepts of the present invention without an appreciable loss in the flexibility of the programmable circuit.

BRIEF DESCRIPTION OF THE DRAWINGS

The invention and its modes of use and advantages are best understood by reference to the following description of illustrative embodiments when read in conjunction with the accompanying drawings, wherein:

FIGURE 1 illustrates a possible implementation of certain concepts of the present invention;

FIGURE 2 illustrates association of a minimum- length, fully-populated segment that may be placed adjacent to a long, depopulated segment according to the present invention;

FIGURE 3 shows the spatial distribution of segmentation points of similar track segments formed consistently with concepts of the present invention;

FIGURE 4 depicts segments of various lengths formed according to the present invention;

FIGURE 5 provides a schematic illustration of a circuit that distributes antifuses with sparsely populated segments;

FIGURE 6 illustrates the concept of variable depopulation within an individual segment according to the various embodiments;

FIGURE 7 shows combining variably depopulated long sparse segments that have density populated segments ends with adjoining short densely populated segments; and

FIGURE 8 demonstrates application of the present inventive concepts to both the X and Y dimensions of a routing architecture.

DETAILED DESCRIPTION OF ILLUSTRATIVE EMBODIMENTS

The illustrative embodiments of the present invention are best understood by referring to the FIGUREs, wherein like numerals are used for like and corresponding parts of the various drawings.

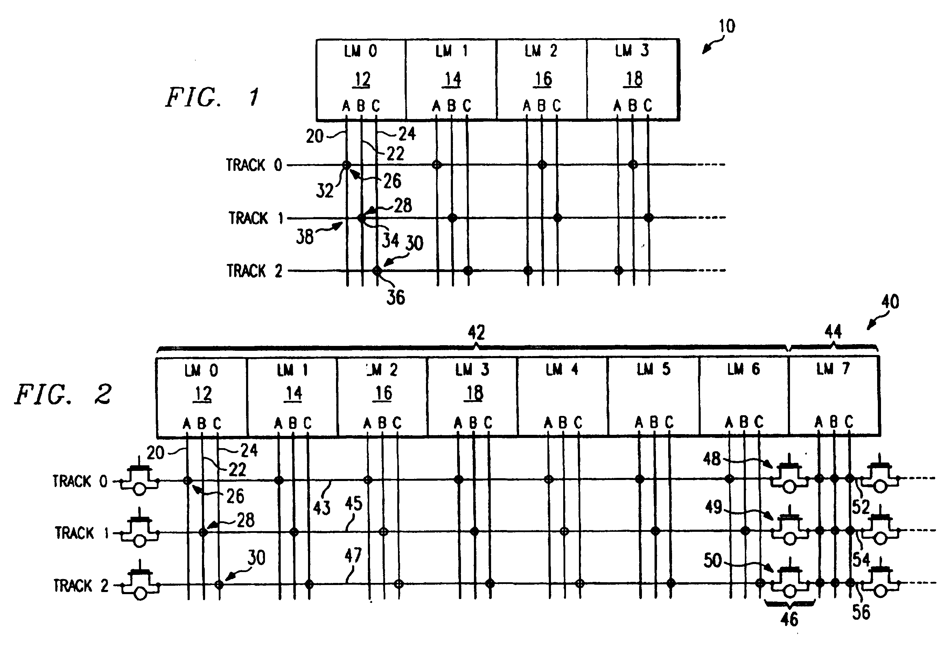

FIGURE 1 shows user-programmable integrated electronic circuit 10 that includes, for example, logic module 0 (LM0) at reference number 12, LM1 at 14, LM2 at 16, and LM3 at 18. Connecting to each of LM0 through LM3 are conductors in the form of input pins such as input pins A, B, and C at respective reference numerals 20, 22, and 24 that may connect to other conductors in the form of tracks such as track 0 at reference numeral 26, track 1 at 28 and track 2 at 30. Antifuses may be in the integrated circuit such as antifuse 32 for connecting track 0 to input pin A, antifuse 34 for connecting track 1 to input pin B, and antifuse 36 for connecting track 2 to input pin C. Thus, as integrated circuit 10 illustrates, although there could be a connection such as at the intersection 38 of pin A with track 1, an antifuse does not appear. As such, a connection between input pin A and track 1 cannot occur in this configuration. Instead, antifuse 34 connects track 1 to input pin B as the only antifuse link. In addition, other user-programmable antifuses further may connect to at least one input/output functional circuit for communicating with external bond pads that connect to the integrated circuit.

An inventive concept of the present embodiment is a methodology for reducing the number of antifuses on segments of various lengths. One using the present embodiment may, therefore, remove antifuses from the segment according to the length of the segment or according to the amount that is optimal for the particular gate density of the device. For example, the gate density of a field programmable gate array (FPGA) an optimal gate density may be selected. On the other hand, there may be additional ways to optimally depopulate the antifuses.

When determining the optimum antifuse depopulation scheme, it is helpful to consider the macro library that the end user will possess for the full fabricated and packaged integrated circuit. It is important, however, that the segment be adequately populated to service the most common macros.

The present embodiment takes advantage of the observation that antifuses may be reduced from a long track with a minimal loss of flexibility as compared to removing a similar number of antifuse interconnects from a short track. Therefore, removing antifuses from a long track will reasonably maintain the flexibility of the long track and, therefore, the flexibility of the integrated circuit using the antifuses.

In defining a long segment versus a short segment, it is possible to distinguish based on the leakage and capacitance that the antifuses contribute to the total leakage and total capacitance of the segment. User-programmable integrated circuit 10 of FIGURE 1 possesses attractive connection capabilities coupled with a generally lower leakage current and reduced capacitance in comparison to known user-programmable circuits having equivalent logic module and conductor configurations. According to the present embodiment, the architecture for designing user-programmable integrated circuit 10 is to segregate the circuit layout of conductors such as track 0, track 1, and track 2 into at least two groups of conductors. The first group has a sufficiently large number of antifuse elements so that the antifuse elements contribute a larger proportion to the total current leakage and capacitance of the group than do the antifuses associated with the second group contribute to the total leakage current and capacitance of the second group. With these distinctions, the present architecture contemplates depopulating selected ones of the antifuse elements from the first group. The selected antifuses are selected to minimally reduce the programmability of the user-programmable integrated circuit while optimally reducing the total leakage and capacitance of the first group.

The following example illustrates one way to calculate the capacitance and leakage current of a user-programmable integrated circuit having antifuses. These calculations make it possible to group segments into groups for which selective depopulation will reduce leakage currents and capacitances significantly. This type of distinction makes possible to calculate the total leakage current and capacitance reduction that selective depopulation may achieve.

The calculations proceed from an analysis of the capacitance of a segment and its associated leakage current. The segment capacitance may be calculated using the following formula:

$$\text{Segment capacitance} =$$

$$[C_{metal} \cdot \text{Length}] + [C_{antifuse} \cdot \text{Number}_{antifuses}] + C_{junction} \tag{1}$$

An example using specific parameter values assists in understanding the concepts of distinguishing among groups of conductors for which to depopulate the anti-fuses. With the following parameter values:

| | |
|---|---|
| $C_{metal} =$ | 0.3 fF/mm, |
| Length $=$ | 200 mm (per logic module width or height), |
| $C_{antifuse} =$ | 5 fF/antifuse |
| Number$_{antifuses} =$ | 16 (per logic module), and |
| $C_{junction} =$ | 100 fF (including segmentation and programming transistors), |

the capacitance calculation gives the following value:

$$\text{Segment capacitance} =$$

$$(0.3\,\text{fF/mm} \cdot 200\,\text{mm}) + (5\,\text{fF}) \cdot (16\,\text{antifuses}) + 100\,\text{fF} = 240\,\text{fF}$$

In general, the capacitance for various depopulation configurations may be the following.

$$C_{total} = \text{total circuit capacitance} = (\text{other} + C_{antifuse}) \tag{2}$$

$$C_{full} = \text{circuit capacitance with fully populated antifuses module width}$$

$$= (100 + 60\,\text{fF/logic module width}) + 80\,\text{fF/logic} \tag{3}$$

$$C_{half} = \text{circuit capacitance with antifuses populated to one-half of the fully populated level}$$

$$= (100 + 60\,\text{fF/logic module width}) + 40\,\text{fF/logic module width} \tag{4}$$

$$C_{quarter} = \text{circuit capacitance with antifuses populated to only one-quarter of the fully populated level}$$

$$= (100 + 60\,\text{fF/logic module width}) + 20\,\text{fF/logic module width} \tag{5}$$

Table 1, below, provides sample tabulations for the capacitance associated with various length tracks.

TABLE 1

| Track Segment Length | $C_{full}$ (fF) | $C_{half}$ (fF) | $C_{quarter}$ (fF) | Cap Reduction From 50% Depop | Cap Reduction From 75% Depop |
|---|---|---|---|---|---|
| 1 Segment | 240 | 200 | 180 | 16.7% | 25% |
| 2 Segments | 380 | 300 | 260 | 21% | 31.5% |
| 5 Segments | 800 | 600 | 500 | 25% | 37.5% |
| 10 Segments | 1500 | 1100 | 900 | 26.7% | 40% |
| 20 Segments | 2900 | 2100 | 1700 | 27.6% | 41.3% |
| 100 Segments | 14100 | 10100 | 8100 | 28.3% | 42.6% |

A further example relates to the case of a segment crossing multiple lines. The relationship takes the form:

$$C_{total} = (100 + 60W) + [80W \cdot (\text{depopulation factor})] \qquad (6)$$

where W = the number of lines a segment crosses. The present embodiment, therefore, provides as much as a 25% reduction in net loading by depopulating segments from 4 to 8 logic modules long by 50%. We could achieve a 40% reduction in net load by depopulating segments 28 logic modules long by 75%.

Taking yet another example, if

$C_{metal} =$ 0.3 fF/mm,
Length = 200mm,
$C_{antifuse} =$ 1 fF/antifuse,
$Number_{antifuse} =$ 16 antifuses, and
$C_{junction} =$ 100 fF,

then

$$C_{total} = (\text{other}) + C_{antifuse} \qquad (7)$$

$$C_{full} = (100 + 60 \text{ fF/logic module width}) + 16 \text{ fF} \qquad (8)$$

$$C_{half} = (100 + 60 \text{ fF/logic module width}) + 8 \text{ fF} \qquad (9)$$

$$C_{quarter} = (100 + 60 \text{ fF/logic module width}) + 2 \text{ fF} \qquad (10)$$

Table 2 uses the equation (7) through (10) to derive sample capacitance values for tracks of varying lengths. This allows illustrating the impact of depopulation on capacitance.

TABLE 2

| Track Segment Length | $C_{Full}$ (fF) | $C_{Half}$ (fF) | $C_{Qtr}$ (fF) | C reduction from 50% depopulation |
|---|---|---|---|---|
| 1 Segment | 176 | 168 | 164 | 4.7% |
| 2 Segments | 252 | 236 | 228 | 6.3% |
| 8 Segments | 708 | 644 | 612 | 9.0% |
| 10 Segments | 860 | 780 | 740 | 9.3% |

TABLE 2 (continued)

| Track Segment Length | $C_{Full}$ (fF) | $C_{Half}$ (fF) | $C_{Qtr}$ (fF) | C reduction from 50% depopulation |
|---|---|---|---|---|
| 20Segments | 1620 | 1460 | 1380 | 9.8% |

In general, with a segment crossing W lines:

$$C_{total} = (100 + 60W) + [16W * (\text{depopulation factor})] \qquad (11)$$

This example shows that if technology were able to produce antifuses with only 1fF capacitance, it is doubtful that antifuse depopulation would improve performance. As this example shows, a 50% depopulation only results in a 5% to 10% net load reduction.

In determining the proper amount of depopulation, as well as the appropriate distinctions between those segments for which selective depopulation is helpful, certain antifuse defective materials are not ideal insulators (such as amorphous silicon, a-Si). Selective depopulation can be employed to reduce the leakage current without an unacceptable reduction in signal routability or programmability. If leakage current is 50 nA per antifuse at 5 volts and 125°C and can be attributed entirely due to a-Si antifuses in defect-free CM0S, then the values of Table 3 can be calculated to study the impact of depopulation on leakage. In Table 3, the parameters NT means number of tracks, SL means segment length, NA means number of antifuses, and AL means antifuse leakage. With a segment crossing multiple tracks, W, the total capacitance equation takes the form:

$$C_{TOTAL} = (100 + 60W) + 16W \text{ (depopulation factor)} \qquad (12)$$

40 tracks x 58 logic modules wide = 2320 potential segments/channel. Using this scheme to depopulate the horizontal routing tracks, therefore, provides a 50% reduction in leakage. From this example of capacitance and leakage analysis, the preferred embodiment for this example technology is to depopulate 50% of a segment 5-9 logic modules wide and 75% of segment 10-20 logic modules wide. One could easily go through this analysis employing parameter characteristics of one's own technology to quickly derive an embodiment well suited for that technology.

Table 3

| Seg. LM Span | NT | SL | NA | AL 100% Pop'n | AL @ 75 Pop'n | AL @ 50 Pop'n | AL @ 25% Pop'n |
|---|---|---|---|---|---|---|---|
| 1 | 1 | 58 | 928 | 46mA | 35mA | 23mA | 12mA |
| 2-4 | 8 | 464 | 7424 | 371mA | 278mA | 186 | 93mA |
| 5-9 | 17.2 | 998 | 15970 | 799mA | 599mA | 399 | 200mA |
| 10-20 | 13.8 | 800 | 12800 | 640mA | 480mA | 320 | 160mA |

The present invention has application in a wide variety of configurations that embody numerous inventive concepts. FIGURE 2, therefore, shows an alternative embodiment that adjoins a selectively depopulated long segment of an integrated circuit with a densely populated short segment through a set of segmentation transistors. Referring to selectively depopulated integrated circuit 40, there appears selectively depopulated long segments 42 that adjoins fully and densely populated segments 44 by way of segmentation transistor/antifuses 46. Selectively depopulated long segment 42 includes, for example, logic modules LM0 through LM6. For each logic module LM0 through LM6, three input pins A, B, and C lead to track 0, track 1, and track 2. For each of track 0 segment 43, track 1 segment 45, and track 2 segment 47, segmentation transistors 48, 49, and 50, respectively, connect to short segment tracks 52, 54, and 56. LM7 also has input pins A, B, and C that intersect track 0 at segment 52, track 1 at segment 54, and track 2 segment 56. As opposed to having sparsely populated antifuses, short segments 44 includes an antifuse at each of the input pins A, B, and C for each of the short segments 52, 54, and 56. The result is a total of nine antifuses for the short segments.

An attractive feature of segmentation fuses 46, however, is that only if it is necessary to adjoin a short segment 44 to a long segment 42 does the densely populated segment 44 connect to a sparsely populated long segment 42. As a result, track 0, for example, may jumper to track 0 segment 52 by programming the segmentation antifuse which is electrically parallel to transistor 48. Alternatively, segmentation transistor 49 may maintain an open between track 1 segment 45 and segment 54 so that the higher per-unit-length leakage current and capacitance of the dense antifuse portion of segment 54 does not affect the operation of long segment 42.

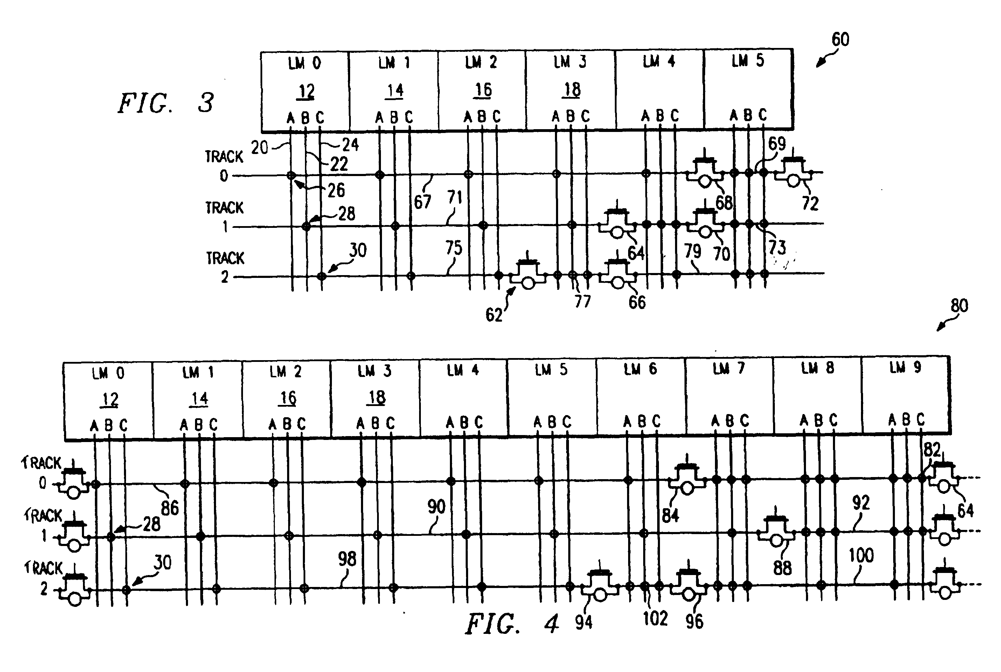

FIGURE 3 illustrates a further embodiment of the present invention that includes spatially distributed or staggered segmentation points of similar track segments. This type of staggering improves routability in the user-programmable integrated circuit 60. Thus, the staggered user-programmable integrated circuit 60 includes logic modules LM0 through LM5, each having associated input pins A, B, and C. Within user-programmable integrated circuit 60 are segmentation transistors such as transistors 62, 64, 66, 68, 70 and 72. The segmentation transistors may be placed at other points within user-programmable integrated circuit 60. Thus, instead of the alignment of the segmentation transistors that appears in FIGURE 2, the segmentation transistors of FIGURE 23 are at different points along the various tracks. The result is an improvement in the general routability of user-programmable integrated circuit 60 or the similar user programmable integrated circuit 10 of FIGURE 1.

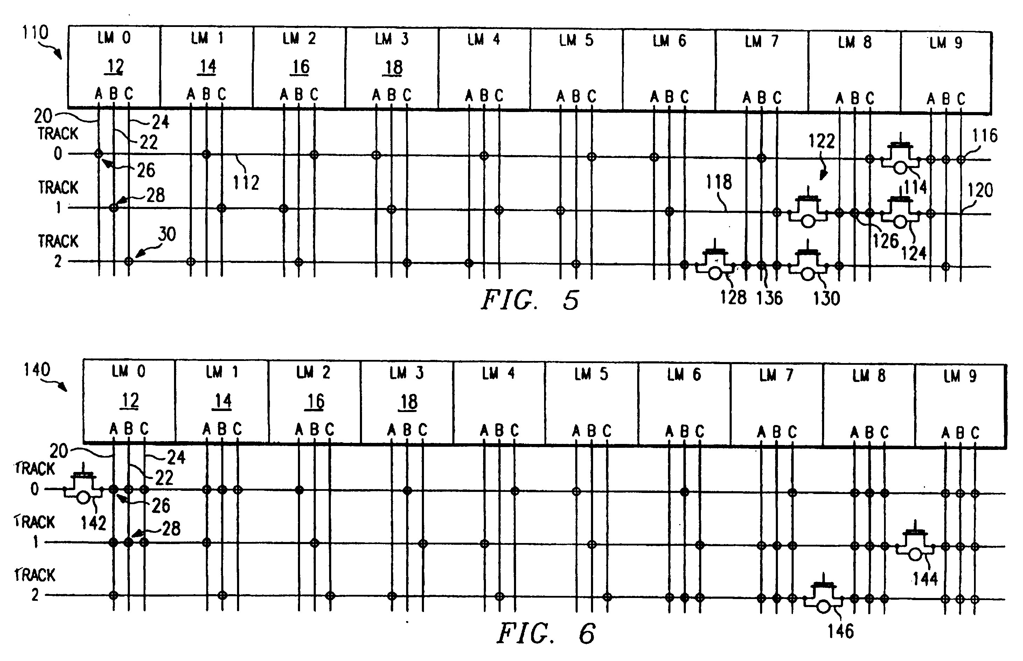

FIGURE 4 shows another example of long segments that have different lengths. The circuit diagrams of FIGURES 1 through 7 show very simple three-input logic modules to illustrate this invention. One should note that typical logic modules may have six to ten inputs or more in antifuse-based FPGA architectures. Thus, in practical cases, the sparsely-populated segments may have more than one potential populated input antifuse location. In such a case, circuitry architects may apply information from the macro library and the associated statistics of macro utilization to determine which logic module inputs to most frequently populate or, conversely, which logic module inputs to depopulate more frequently. At the same time, designers should consider minimizing the reductions in routability due to depopulation.

User-programmable integrated circuit 80 of FIGURE 4 illustrates dense segments of various lengths. Thus, dense segment 82 appears on track 0 and through segmentation transistor 84 joins track 0 portion 86. Similarly, segmentation transistor 88 separates track 1 portion 90 from the short dense segment 92. Note that sparsely populated segment 86 of track 0 and sparsely populated segment 90 of track 1 have different lengths. The same is true of densely populated segment 82 and densely populated segment 92. In a similar fashion, segmentation transistors 94 and 96 separate track 2 into three segments. Two segments are sparsely populated, i.e., segments 98 and 100, while short, densely populated segment 102 is isolated by segmentation transistors 94 and 96.

FIGURE 5 shows user-programmable integrated circuit 10 which is similar to that of FIGURE 4 and illustrates the desirability of distributing the logic module inputs that are to be populated on sparsely populated segments. Thus, segmentation transistor 114 separates sparsely populated segment 112 from densely populated segment 116. Likewise, segmentation transistors 122 and 124, respectively, separate sparsely populated segments 118 and 120 from short, densely populated segment 126. Also, segmentation transistors 128 and 130 separate, respectively, selectively depopulated segments 132 and 134 from densely populated short segment 136.

User-programmable integrated circuit 110, therefore, achieves a desired effect of providing a sparse segment to access two different functional inputs. This may be important for architectures that use logic modules (such as multiplexer-based logic modules) which have asymmetric input functionality. For example, if the logic modules were to perform a two-input NAND gate, the inputs may be required at input pins B and C of the logic module such that input pins A and C may not achieve the desired result. Shifting populated inputs around on a segment allows the placement tool to shift the macro instance into routable positions.

In FIGURE 6 appears yet a further embodiment of user-programmable integrated circuit 140 that includes segmentation transistors 142 on track 0, segmentation transistor 144, and segmentation transistor 146 on track 2. The embodiment of FIGURE 6 illustrates the concept of variable depopulation within an individual segment. One of the concepts that user-programmable integrated circuit 140 of FIGURE 6 embodies is that of increasing routability while still achieving significant reduction in the number of antifuses and their associated parasitic leakage current and capacitance characteristics. User-programmable integrated circuit 140 allows a segment to traverse a significant distance between a driving node such as LM0 and a destination point such as LM8 or LM9 as they connect with track 0, for example.

As track 0 of user-programmable integrated circuit 140 illustrates, between LM0 or LM1 and LM8 or LM9, the signal may be required very infrequently. As such, this distance is selectively depopulated. Increasing the density of the antifuse population near the ends of the segment, the probability is increased that the segment's signal will be available to the required logic module input. This also may reduce the frequency of requiring a short, dense segment being connected to the long, sparse segment.

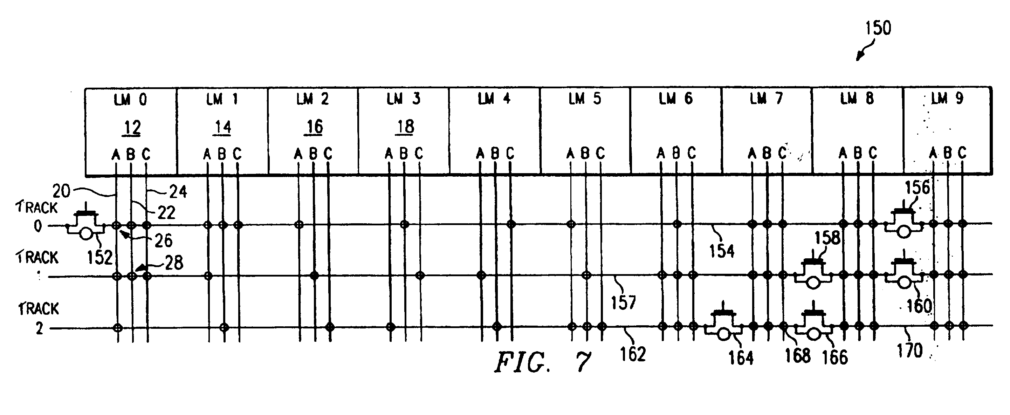

In FIGURE 7, the combination of several inventive concepts of the present invention appear. For example, FIGURE 7 includes a long track 0 segmentation transistor 152 that connects to densely populated portions of long segment 154. These densely populated portions go to LM0 and LM1. Another densely populated portion of long segment 154 appears at LM7 and LM8. Separating LM8 from LM9, which is also densely populated is segmentation transistor 156. On track 1 appears densely populated segment LM0 that is sparsely populated until the densely populated portion associated with LM6 and LM7. Segmentation transistor 158 separates LM7 and LM8 connections along track 1, while segmentation transistor 160 separates LM8 and LM9 antifuses along track 1. On track 2, sparsely populated portions of long segment 162 continue until it reaches that portion of long segments 162 associated with LM5 and LM6. Segmentation transistor 164 separates LM6 and LM7, while segmentation transistor 166 separates short segment 168 from densely populated segment 170.

User-programmable integrated circuit 150 of FIGURE 7, therefore, illustrates the combination of including a variably depopulated long sparse segment having densely populated portions or segments ends together with an adjoining short, densely populated segments. As in the case of user-programmable integrated circuit 80 of FIGURE 4, the short, densely populated segments of user-programmable integrated circuit 150 of FIGURE 7 may be of variable length.

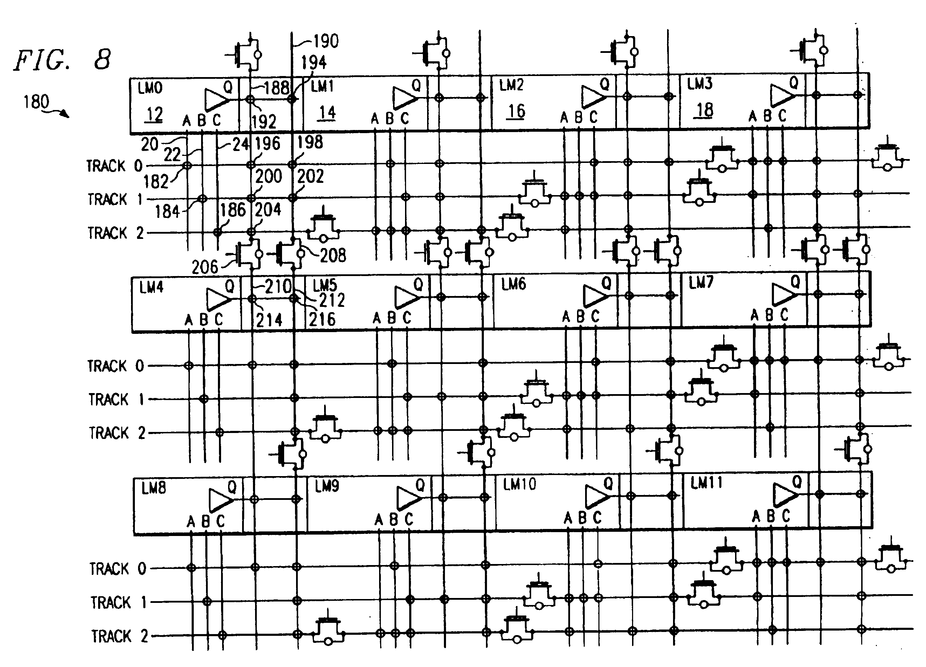

FIGURE 8 shows yet a further embodiment of the present invention in the form of user-programmable integrated circuit 180 that shows how inventive concepts of the various embodiments may be employed in both X and Y dimensions of a routing architecture. For example, in user-programmable integrated circuit 180, LM0 has input pins A, B, and C that, respectively, have antifuse links 182, 184, and 186 that associate, again respectively, with track 0, track 1 and track 2. These are the above-described connections that appear in the y direction. Also, however, output pin Q may exit LM0 to intersect vertical tracks 188 and 190 and antifuses 192 and 194, respectively. Vertical tracks 188 and 190 may also intersect at antifuses 196 and 198 with track 0, and antifuses 200 and 202 with track 1 and, for example at antifuse 204 with track 2. Moreover, segmentation transistors 206 and 208 may, for example, isolate vertical tracks 188 and 190 from vertical track portions 210 and 212 that may connect to output pin Q of LM4 via antifuse links 214 and 216.

User-programmable integrated circuit 180, therefore, attempts to illustrate that the ideas of the various embodiments may be employed in both the x and y dimensions of a routing architecture. The simple case of user-programmable integrated circuit 180 shows the long sparse segments as only two logic module rows. The densely populated short segments are a single row tall. In practical cases, the vertical segment lengths would be longer and may vary. The inventive concepts of the embodiments of FIGURES 1 through 7, above, therefore, may be applied to the vertical routing resources. Furthermore, although the output shown in FIGURE 8 is shown as fusible to the two vertical segments in each column, the output could be hard connected to either vertical or horizontal segments while still being fusible to additional segments running in the same direction or onto external segments adjoining the output segments.

A technical advantage of the present invention is that it provides a way of differentiating between connectors in an integrated electronic circuit for which leakage and capacitance from antifuses contribute more than a desirable amount to the total leakage and capacitance of the connectors.

Another technical advantage of the present invention is that it may be used for a variety of programmable logic devices including, for example, a field programmable gate array (FPGA) to optimize the FPGA's programmability while minimizing the undesirable effects of leakage and capacitance associated with the antifuses that connect the FPGA logic modules to various tracks.

Another technical advantage of the present invention is that it permits selecting particular antifuses to depopulate from a candidate routing architecture according to the potential macros that may be used to program the integrated electronic circuit.

In summary, the present invention includes various embodiments such as a method and system for reducing the total leakage and capacitance in a user-programmable integrated electronic circuit. The user-programmable integrated circuit having conductors that may be connected to one another and to functional circuit blocks by programming the user-programmable antifuses that connect to the conductors and to the functional circuit blocks to form the electronic circuit. The steps of the method include segregating the conductors into at least two segments each having antifuses. The two conductor segments include a first segment and a second segment. The first segment has a sufficiently large number of potential antifuse sites so that if antifuses were located at each of the potential antifuse sites, then the antifuses would contribute a larger proportion to the total leakage current and capacitance of the first segment than do the antifuses of the second segment contribute to the total leakage current and capacitance of the second segment. The method further includes the step of depopulating selected ones of the potential antifuse location of the first segment. The selected antifuses being selected to minimally reduce programmability of the user-programmable integrated circuit while optimally reducing the total leakage current and capacitance of the first design group for, thereby reducing the total leakage capacitance of the electronic circuit.

Although the invention has been described with reference to the above-specified embodiments, this description is not meant to be construed in a limiting sense. Various modifications of the disclosed embodiment, as well as alternative embodiments of the invention will become apparent to persons skilled in the art upon reference to the above description. It is, therefore, intended, that the invention is limited only by the scope of the appended claims.

**Claims**

1. A circuit in a programmable electronic circuit having low leakage currents and low capacitance, comprising:

   a programmable integrated circuit comprising a plurality of conductors and a plurality of functional circuit blocks;

a plurality of programmable antifuses connected to said plurality of conductors and said plurality of functional circuit blocks, said plurality of programmable antifuses designed to connect said plurality of conductors with one another and to said plurality of functional circuit blocks;

at least selected ones of said plurality of conductors being segregated into at least two segments, each said at least two segments including a first segment and a second segment, said first segment comprising a sufficiently large number of potential antifuse locations such that if antifuses were located at each of said potential antifuse locations, then such antifuses would contribute a larger proportion to the total leakage current and capacitance of said first segment than would antifuses located at all potential antifuse locations of said second segment contribute to the total leakage current and capacitance of said second segment;

said ones of said plurality of antifuses associated with said first segment being selectively depopulated to reduce the leakage current and capacitance of said first segment and avoid adversely affecting programmability of said programmable integrated circuit.

2. The circuit of claim 1, for a user-programmable electronic circuit, wherein the programmable integrated circuit design and the programmable antifuses are user-programmable.

3. The circuit of claim 1 or 2, wherein said plurality of programmable antifuses further connect to at least one input/output functional circuit for communicating with external bond pads that connect to the integrated circuit.

4. The circuit of any preceding claim , wherein said first segment comprises long segments of said conductors and wherein said second segment comprises short segments of said conductors.

5. The circuit of any preceding claim , wherein said first segment is distinguished from said second segment by calculating the total leakage and capacitance associated with antifuses among said conductors.

6. The circuit of any preceding claim , wherein said antifuses are selectively depopulated by selectively depopulating one-half of said antifuses from said first segment.

7. The circuit of any preceding claim , wherein said programmable integrated circuit design comprises a field programmable gate array circuit design.

8. The circuit of any of claims 1 to 6, wherein said programmable integrated circuit design comprises a programmable logic device circuit design.

9. The circuit of any preceding claim , wherein said ones of said plurality of antifuses are selectively depopulated as a result of the capacitance level of said antifuses.

10. The circuit of any of Claims 1 to 8, wherein said antifuses associated with said first segment are selectively depopulated as a function of the leakage that said antifuses contribute to the total leakage of said first segment.

11. The circuit of any of Claims 1 to 8, wherein said antifuses associated with said first segment are selectively depopulated according to a macro library associated with the design of said user-programmable integrated circuit.

12. A method for reducing the total leakage and capacitance in a programmable integrated circuit, the programmable integrated circuit having a plurality of conductors that may be connected to one another and to a plurality of functional circuit blocks by programming antifuse elements connected to the plurality of conductors and the plurality of functional circuit blocks to form the electronic circuit, the method comprising the steps of:

segregating at least a portion of the conductors into at least two segments, including a first segment and a second segment, the first segment having a sufficiently large number of potential antifuse locations such that if an antifuse were located at each of the locations, then the total number of antifuses would contribute a larger portion to the total leakage and capacitance of the first segment than would antifuses located at all potential antifuse locations of the second segment contribute to the total leakage capacitance of the second segment; and

depopulating selected ones of the potential antifuse locations of the first segment, the selected potential antifuse locations being selected to avoid adversely affecting programmability of the programmable integrated circuit while reducing the total leakage current and capacitance of the first segment and, thereby, the total leakage capacitance of the electronic circuit.

**13.** The method of Claim 12, further comprising the step of connecting certain ones of the plurality of programmable antifuses further to at least one input/output functional circuit for communicating with external bond pads that connect to the integrated circuit.

**14.** The method of Claim 12 or Claim 13, wherein said segregating step further comprises the step of segregating the first segment as at least one long segment of the conductors and the second segment as at least one short segment of the conductors.

**15.** The method of any of claims 12 to 14, wherein said segregating step further comprises the step of distinguishing the first segment from the second segment by calculating the total leakage and capacitance associated with antifuses among the design conductors.

**16.** The method of any of claims 12 to 15, wherein said depopulating step further comprises the step of selectively depopulating one-half of the design programmable antifuses of the first segment.

**17.** The method of any of claims 12 to 16, further comprising the step of applying said segregating step and said depopulation step to a field programmable gate array circuit design.

**18.** The method of any of claims 12 to 16 , further comprising the step of applying said segregating step and said depopulation step to a programmable logic device circuit design.

**19.** The method of any claims 12 to 18, wherein said depopulating step further comprises the step of selectively depopulating the antifuses based on the capacitance level that the design programmable antifuses comprises of the total capacitance of the first segment.

**20.** The method any of claims 12 to 19, wherein said depopulating step further comprises the step of depopulating the antifuses as a function of the leakage that the antifuses contribute to the total leakage of the first segment.

**21.** The method of any of claims 12 to 20, further comprising the step of selectively depopulated the ones of the plurality of design programmable antifuses associated with the first design group according to a macro library associated with a design of the programmable integrated circuit.


**Patentansprüche**

**1.** Schaltung in einer programmierbaren elektronischen Schaltung mit niedrigen Leckströmen und niedriger Kapazität, mit:

einer programmierbaren integrierten Schaltung, die mehrere Leiter und mehrere Funktionsschaltungsblöcke enthält; mehreren programmierbaren Antischmelzsicherungen, die mit den mehreren Leitern und den mehreren Funktionsschaltungsblöcken verbunden sind, wobei die mehreren programmierbaren Antischmelzsicherungen dafür ausgelegt sind, die mehreren Leiter miteinander und mit den mehreren Funktionsblöcken zu verbinden;
wobei zumindest ausgewählte der mehreren Leiter in wenigstens zwei Segmente getrennt sind, wobei jedes der wenigstens zwei Segmente ein erstes Segment und ein zweites Segment enthält, wobei das erste Segment eine ausreichend große Anzahl von potentiellen Antischmelzsicherungsstellen aufweist, so daß dann, wenn Antischmelzsicherungen an jeder der potentiellen Antischmelzsicherungsstellen angeordnet wären, diese Antischmelzsicherungen einen größeren Anteil zu dem Gesamtleckstrom und der Gesamtkapazität des ersten Segments beitragen würden als Antischmelzsicherungen, die an allen potentiellen Antischmelzsicherungsstellen des zweiten Segments angeordnet wären, zu dem Gesamtleckstrom und der Gesamtkapazität des zweiten Segments beitragen würden;
wobei diejenigen der mehreren Antischmelzsicherungen, die dem ersten Segment zugeordnet sind, selektiv ausgedünnt sind, um den Leckstrom und die Kapazität des ersten Segments zu verringern und eine Beeinträchtigung der Programmierbarkeit der programmierten integrierten Schaltung zu vermeiden.

**2.** Schaltung nach Anspruch 1 für eine benutzerprogrammierbare elektronische Schaltung, bei welcher die programmierbare integrierte Schaltungsstruktur und die programmierbaren Antischmelzsicherungen benutzerprogrammierbar sind.

3. Schaltung nach Anspruch 1 oder 2, bei welcher die mehreren programmierbaren Antischmelzsicherungen ferner Verbindungen zu wenigstens einer Eingabe-/Ausgabe-Funktionsschaltung herstellen, um mit externen Anschlußflächen, die mit der integrierten Schaltung verbunden sind, zu kommunizieren.

4. Schaltung nach einem der vorhergehenden Ansprüche, bei welcher das erste Segment lange Segmente der Leiter enthält und bei welcher das zweite Segment kurze Segmente der Leiter enthält.

5. Schaltung nach einem der vorhergehenden Ansprüche, bei welcher das erste Segment von dem zweiten Segment dadurch unterschieden wird, daß der Gesamtleckstrom und die Gesamtkapazität, die Antischmelzsicherungen bei den Leitern zugeordnet sind, berechnet werden.

6. Schaltung nach einem der vorhergehenden Ansprüche, bei welcher die Antischmelzsicherungen dadurch selektiv ausgedünnt werden, daß die Hälfte der Antischmelzsicherungen von dem ersten Segment selektiv ausgedünnt werden.

7. Schaltung nach einem der vorhergehenden Ansprüche, bei welcher die programmierbare integrierte Schaltungsstruktur eine feldprogrammierbare Gate-Array-Schaltungsstruktur umfaßt.

8. Schaltung nach einem der Ansprüche 1 bis 6, bei welcher die programmierbare integrierte Schaltungsstruktur eine programmierbare Logikanordnungs-Schaltungsstruktur umfaßt.

9. Schaltung nach einem der vorhergehenden Ansprüche, bei welcher die besagten der mehreren Antischmelzsicherungen aufgrund des Kapazitätspegels der Antischmelzsicherungen selektiv ausgedünnt werden.

10. Schaltung nach einem der Ansprüche 1 bis 8, bei welcher die dem ersten Segment zugeordneten Antischmelzsicherungen in Abhängigkeit von dem Leckstrom, den diese Antischmelzsicherungen zu dem Gesamtleckstrom des ersten Segments beitragen, selektiv ausgedünnt werden.

11. Schaltung nach einem der Ansprüche 1 bis 8, bei welcher die dem ersten Segment zugeordneten Antischmelzsicherungen gemäß einer Makrobibliothek, die der Struktur der benutzerprogrammierbaren integrierten Schaltung zugeordnet ist, selektiv ausgedünnt werden.

12. Verfahren zur Reduzierung des Gesamtleckstroms und der Gesamtkapazität in einer programmierbaren integrierten Schaltung, wobei die programmierbare integrierte Schaltung mehrere Leiter hat, die miteinander und mit mehreren Funktionsblöcken durch Programmierung von Antischmelzsicherungselementen, die mit den mehreren Leitern und den mehreren Funktionsblöcken verbunden sind, zur Bildung der elektronischen Schaltung verbunden werden können, wobei das Verfahren die folgenden Schritte umfaßt:

Trennen wenigstens eines Teils der Leiter in wenigstens zwei Segmente, die ein erstes Segment und ein zweites Segment enthalten, wobei das erste Segment eine ausreichend große Anzahl von potentiellen Antischmelzsicherungsstellen aufweist, so daß dann, wenn eine Antischmelzsicherung an jeder der Stellen angeordnet wäre, die Gesamtzahl an Antischmelzsicherungen einen größeren Anteil zu dem Gesamtleckstrom und der Gesamtkapazität des ersten Segments beitragen würde als Antischmelzsicherungen, die an allen potentiellen Antischmelzsicherungsstellen des zweiten Segments angeordnet wären, zu dem Gesamtleckstrom und der Gesamtkapazität des zweiten Segments beitragen würden; und
Ausdünnen ausgewählter der potentiellen Antischmelzsicherungsstellen des ersten Segments, wobei die ausgewählten potentiellen Antischmelzsicherungsstellen so gewählt werden, daß eine Beeinträchtigung der Programmierbarkeit der programmierbaren integrierten Schaltung vermieden wird, während der Gesamtleckstrom und die Gesamtkapazität des ersten Segments und dadurch die Gesamtleckstromkapazität der elektronischen Schaltung reduziert werden.

13. Verfahren nach Anspruch 12, das ferner den Schritt umfaßt, bestimmte der mehreren programmierbaren Antischmelzsicherungen ferner mit wenigstens einer Eingabe-/Ausgabe-Funktionsschaltung zu verbinden, um mit externen Anschlußflächen, die mit der integrierten Schaltung verbunden sind, zu kommunizieren.

14. Verfahren nach Anspruch 12 oder 13, bei welchem der Schritt des Trennens ferner den Schritt enthält, das erste Segment als wenigstens ein langes Segment der Leiter und das zweite Segment als wenigstens ein kurzes Segment der Leiter zu trennen.

**15.** Verfahren nach einem der Ansprüche 12 bis 14, bei welchem der Schritt des Trennens den Schritt umfaßt, das erste Segment von dem zweiten Segment durch Berechnung des Gesamtleckstroms und der Gesamtkapazität, die Antischmelzsicherungen bei den Leitern der Struktur zugeordnet sind, zu unterscheiden.

**16.** Verfahren nach einem der Ansprüche 12 bis 15, bei welchem der Schritt des Ausdünnens ferner den Schritt umfaßt, die Hälfte der programmierbaren Antischmelzsicherungen des ersten Segments auszudünnen.

**17.** Verfahren nach einem der Ansprüche 12 bis 16, das ferner den Schritt umfaßt, den Schritt des Trennens und den Schritt des Ausdünnens bei einer feldprogrammierbaren Gate-Array-Schaltungsstruktur anzuwenden.

**18.** Verfahren nach einem der Ansprüche 12 bis 16, das ferner den Schritt umfaßt, den Schritt des Trennens und den Schritt des Ausdünnens bei einer programmierbaren Logikanordnungs-Schaltungsstruktur anzuwenden.

**19.** Verfahren nach einem der Ansprüche 12 bis 18, bei welchem der Schritt des Ausdünnens ferner den Schritt umfaßt, die Antischmelzsicherungen aufgrund des Kapazitätspegels auszudünnen, den die programmierbaren Antischmelzsicherungen der Struktur von der Gesamtkapazität des ersten Segments aufweisen.

**20.** Verfahren nach einem der Ansprüche 12 bis 19, bei welchem der Schritt des Ausdünnens ferner den Schritt umfaßt, die Antischmelzsicherungen in Abhängigkeit von dem Leckstrom auszudünnen, den die Antischmelzsicherungen zu dem Gesamtleckstrom des ersten Segments beitragen.

**21.** Verfahren nach einem der Ansprüche 12 bis 20, das ferner den Schritt umfaßt, diejenigen der mehreren programmierbaren Antischmelzsicherungen der Struktur, die der ersten Strukturgruppe zugeordnet sind, gemäß einer Makrobibliothek, die der Struktur der programmierbaren integrierten Schaltung zugeordnet ist, selektiv auszudünnen.


**Revendications**

**1.** Circuit dans un circuit électronique programmable présentant de faibles courants de fuite et une faible capacité, comprenant :

un circuit intégré programmable comprenant une pluralité de conducteurs et une pluralité de blocs de circuits fonctionnels;
une pluralité d'interconnexions "antifusible" connectées à ladite pluralité de conducteurs et à ladite pluralité de blocs de circuits fonctionnels, ladite pluralité d'interconnexions antifusible programmables étant conçue de manière à connecter ladite pluralité de conducteurs entre eux et à ladite pluralité de blocs de circuits fonctionnels;
au moins des premiers conducteurs sélectionnés parmi ladite pluralité de conducteurs étant séparés en au moins deux segments, chacun desdits au moins deux segments comprenant un premier segment et un second segment, ledit premier segment comprenant un nombre suffisamment élevé d'emplacements potentiels d'interconnexions antifusible, tel que, si les interconnexions antifusible étaient situées en chacun desdits emplacements potentiels d'interconnexions antifusible, alors de telles interconnexions antifusible contribueraient en une proportion plus importante au courant de fuite total et à la capacité totale dudit premier segment, que celle avec laquelle des interconnexions antifusible situées en tous les emplacements potentiels d'interconnexions antifusible dudit second segment interviendraient dans le courant de fuite total et dans la capacité totale dudit second segment;
lesdites premières interconnexions antifusible de ladite pluralité d'interconnexions antifusible associées audit premier segment étant supprimées sélectivement afin de réduire le courant de fuite et la capacité dudit premier segment et d'éviter d'affecter de façon nuisible la capacité de programmation dudit circuit intégré programmable.

**2.** Circuit selon la revendication 1 pour un circuit électronique programmable par un utilisateur, dans lequel l'agencement du circuit intégré programmable et les interconnexions antifusible programmables sont programmables par l'utilisateur.

**3.** Circuit selon la revendication 1 ou 2, dans lequel ladite pluralité d'interconnexions antifusible programmables sont en outre connectées à au moins un circuit fonctionnel d'entrée/de sortie pour communiquer avec des plots externes de connexion qui établissent une connexion avec le circuit intégré.

4. Circuit selon l'une quelconque des revendications précédentes, dans lequel ledit premier segment comprend de long segments desdits conducteurs et dans lequel ledit second segment comprend de courts segments desdits conducteurs.

5. Circuit selon l'une quelconque des revendications précédentes, dans lequel ledit premier segment se distingue dudit second segment par le calcul du courant de fuite total et de la capacité totale associées aux interconnexions antifusible entre lesdits conducteurs.

6. Circuit selon l'une quelconque des revendications précédentes, dans lequel lesdites interconnexions antifusible sont supprimées sélectivement par suppression sélective de la moitié desdites interconnexions antifusible dans ledit premier segment.

7. Circuit selon l'une quelconque des revendications précédentes, dans lequel ledit agencement du circuit intégré programmable comprend un agencement du circuit à réseau de portes programmable par l'utilisateur.

8. Circuit selon l'une quelconque des revendications 1 à 6, dans lequel ledit agencement du circuit intégré programmable comprend un agencement du circuit à dispositif logique programmable.

9. Circuit selon l'une quelconque des revendications précédentes, dans lequel lesdites premières interconnexions de ladite pluralité d'interconnexions antifusible sont supprimées sélectivement en raison du niveau de capacité desdites interconnexions antifusible.

10. Circuit selon l'une quelconque des revendications 1 à 8, dans lequel lesdites interconnexions antifusible associées audit premier segment sont supprimées sélectivement en fonction de la fuite, à laquelle lesdites interconnexions antifusible contribuent pour fournir la fuite totale dudit premier segment.

11. Circuit selon l'une quelconque des revendications 1 à 8, dans lequel lesdites interconnexions antifusible associées audit premier segment sont supprimées sélectivement conformément à une bibliothèque de macro-instructions associée au type dudit circuit intégré programmable par l'utilisateur.

12. Procédé pour réduire la fuite totale et la capacité totale dans un circuit intégré programmable, le circuit intégré programmable comportant une pluralité de conducteurs qui peuvent être connectés entre eux et à une pluralité de blocs de circuits fonctionnels par programmation d'éléments d'interconnexions antifusible connectées à la pluralité de conducteurs et à la pluralité de blocs de circuits fonctionnels pour former le circuit électronique, le procédé comprenant les étapes consistant à : séparer au moins une partie des conducteurs en au moins deux segments, comprenant un premier segment et un second segment, ledit premier segment comprenant un nombre suffisamment élevé d'emplacements potentiels d'interconnexions antifusible tel que, si une interconnexion antifusible était située en chacun des emplacements, alors le nombre total d'interconnexions antifusible contribuerait à fournir une proportion plus importante du courant de fuite total et de la capacité totale dudit premier segment, que celle avec laquelle les interconnexions antifusible situées en tous les emplacements potentiels d'interconnexions antifusible du second segment interviendraient dans le courant de fuite total et la capacité totale du second segment; supprimer des premiers emplacements sélectionnés parmi les emplacements potentiels d'interconnexions antifusible du premier segment, des emplacements potentiels sélectionnés d' interconnexions antifusible étant sélectionnés de manière à éviter d'affecter de façon nuisible la capacité de programmation du circuit intégré programmable, tout en réduisant le courant de fuite total et la capacité totale du premier segment et, de ce fait, le courant de fuite total et la capacité totale du circuit électronique.

13. Procédé selon la revendication 12, comprenant en outre l'étape consistant à connecter, en supplément, certaines premières interconnexions antifusible parmi la pluralité d'interconnexions antifusible programmables, à au moins un circuit fonctionnel d'entrée/de sortie pour communiquer avec des plots externes de connexion qui sont connectés au circuit intégré.

14. Procédé selon la revendication 12 ou 13, dans lequel ladite étape de séparation comprend en outre l'étape consistant à séparer le premier segment en tant qu'au moins un long segment des conducteurs et le second segment en tant qu'au moins un segment court des conducteurs.

15. Procédé selon l'une quelconque des revendications 12 à 14, dans lequel ladite étape de séparation comprend en outre l'étape consistant à distinguer le premier segment du second segment par calcul du courant de fuite total et de la capacité totale, associés aux interconnexions antifusible entre les conducteurs créés à la conception.

16. Procédé selon l'une quelconque des revendications 12 à 15, selon lequel ladite étape de suppression comprend en outre l'étape consistant à supprimer sélectivement la moitié des interconnexions antifusible programmables du premier segment créées à la conception.

17. Procédé selon l'une quelconque des revendications 12 à 16, comprenant en outre l'étape consistant à appliquer ladite étape de séparation et ladite étape de suppression à un agencement de circuit à réseau de portes programmable par l'utilisateur.

18. Procédé selon l'une quelconque des revendications 12 à 16, comprenant en outre l'étape consistant à appliquer ladite étape de séparation et ladite étape de suppression à un agencement de circuit à dispositif logique programmable.

19. Procédé selon l'une quelconque des revendications 12 à 18, selon lequel ladite étape de suppression comprend en outre l'étape consistant à supprimer sélectivement les interconnexions antifusible sur la base du niveau de capacité que les interconnexions antifusible programmables créées à la conception forment parmi la capacité totale du premier segment.

20. Procédé selon l'une quelconque des revendications 12 à 19, selon lequel ladite étape de suppression comprend en outre l'étape consistant à supprimer les interconnexions antifusible en fonction de la fuite, à la formation de laquelle les interconnexions antifuse contribuent dans la fuite totale du premier segment.

21. Procédé selon les revendications 12 à 20, comprenant en outre l'étape consistant à supprimer sélectivement les premières interconnexions de la pluralité d'interconnexions programmables antifusible créées à la conception, associées au premier groupe de conception pour former une librairie de macro-instructions associées à la conception du circuit intégré programmable.

EP 0 667 679 B1

FIG. 1

FIG. 2

15

FIG. 3

FIG. 4

EP 0 667 679 B1

FIG. 5

FIG. 6

FIG. 7

FIG. 8